# FASCICULE DE BREVET EUROPEEN

(11) **EP 0 562 669 B1**
(45) Date de publication et mention de la délivrance du brevet: **20.01.1999**
(21) Numéro de dépôt: 93200755.2
(22) Date de dépôt: 16.03.1993
(51) Int. Cl.: G11C 16/06

(54) **Dispositif comportant une mémoire et des moyens pour valider des données inscrites dans cette mémoire**
Anordnung mit einem Speicher und Mitteln zur Datenbestätigung.
Device comprising a memory and means for datavalidation in this memory

(30) Priorité: 25.03.1992 FR 9203619
(43) Date de publication de la demande: 29.09.1993
(73) Titulaire: DE LA RUE CARTES ET SYSTEMES, 75013 Paris (FR)
(72) Inventeur: Leterrier, Benoît, Société Civile S.P.I.D., F-75008 Paris (FR)
(74) Mandataire: Barbin le Bourhis, Joel

(56) Documents cités:
- EP-A- 0 340 981
- WO-A-92/04716
- FR-A- 2 665 791

## Description

La présente invention concerne un dispositif comportant une mémoire et des moyens pour valider des données inscrites dans cette mémoire.

Un tel dispositif trouve d'importantes applications notamment lorsqu'il sert de dispositif de paiement (carte à microcircuit).

Un problème qui se pose avec ce genre de dispositif est la validation de la transaction ou la validation de la donnée inscrite. Il est important que celle-ci soit enregistrée avec beaucoup de fiabilité. Pour cela, on utilise souvent une mémoire morte reprogrammable (EEPROM) pour contenir la valeur et la validité de la dernière transaction. Ce problème se complique en outre par le fait que les mémoires reprogrammables (EEPROM) ne supportent qu'un nombre limité d'écriture et que pour obtenir un usage intensif, il est proposé de l'organiser en mémoire circulaire de sorte que chaque donnée inscrite n'occupe pas la place de la précédente. Ainsi, le nombre d'emplacements de cette mémoire circulaire augmente d'autant le nombre possible de transactions.

Dans le brevet EP 0 398 545 on décrit un tel dispositif où l'on utilise un élément binaire ou drapeau pour signaler si la donnée entrée l'est valablement. La gestion de ce drapeau nécessite tout un traitement ; notamment il faut prévoir une écriture supplémentaire pour le positionner. Dans le cas d'une mémoire EEPROM, le temps nécessaire d'écriture en mémoire est relativement long (plusieurs millisecondes). Cette écriture est donc pénalisante et est considérée comme désavantageuse.

La présente invention propose un dispositif du genre cité dans le préambule, dans lequel il n'est pas nécessaire d'utiliser un élément binaire de drapeau.

Par ailleurs, le document WO-A-9204716 décrit un dispositif de mise à jour d'informations dans une mémoire, qui peut être organisée en mémoire circulaire, mais qui comporte aussi un indicateur logique changeant d'état après que la valeur vérifiée ait été reconnue correcte.

L'invention permet d'éviter ces inconvénients.

Plus précisément, l'invention concerne donc un dispositif comportant une mémoire et des moyens de validation d'une donnée inscrite dans ladite mémoire, cette dernière étant organisée en mémoire circulaire, caractérisé en ce que lesdits moyens de validation assignent au moins deux emplacements "neutres" résultant de leur effacement, contiguëment à l'emplacement de la mémoire où vient de s'inscrire la donnée à valider.

La description suivante, accompagnée des dessins ci-annexés, le tout donné à titre d'exemple non limitatif, fera bien comprendre comment l'invention peut être réalisée.

La figure 1 montre un dispositif conforme à l'invention.

La figure 2 montre comment est inscrite la mémoire non volatile.

La figure 3 est un organigramme représentant la mise en oeuvre des moyens de validation.

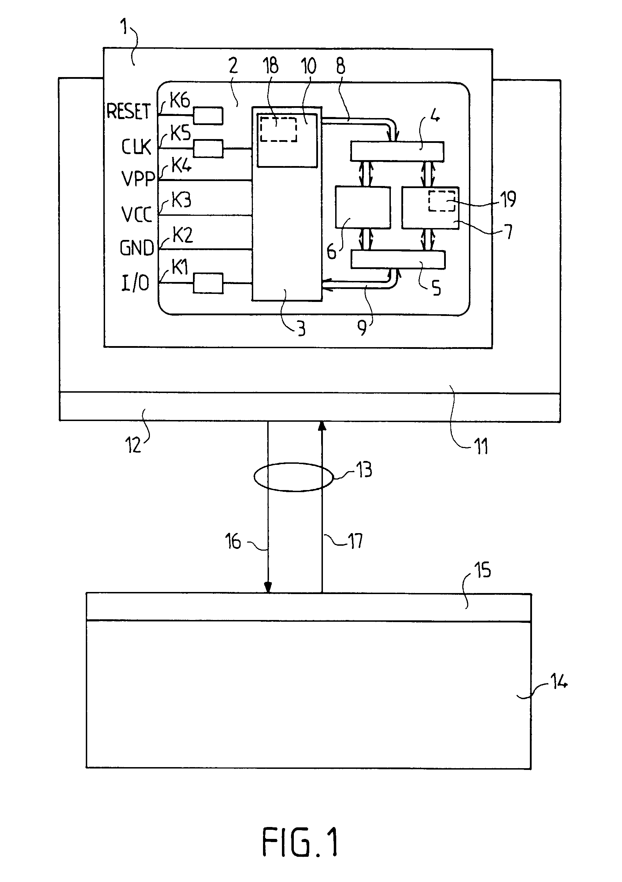

Sur la figure 1 est représenté un support électronique amovible et portatif 1 appelé carte à microcircuit ou carte dans la suite du texte. Le microcircuit 2 de la carte présente une architecture connue pour l'essentiel. Cette architecture consiste en un microprocesseur 8 bits 3 qui peut incorporer une mémoire RAM 10, deux mémoires vives RAM montées en tampon 4 et 5, une mémoire de programme ROM 6 et une mémoire de données de type EPROM ou EEPROM 7. La mémoire RAM 4 est reliée au microprocesseur 3 par un bus d'adresses bidirectionnel 8 et la mémoire RAM 5 est reliée au microprocesseur par un bus de données bidirectionnel 9. Par ailleurs, chaque RAM 4, 5 est reliée aux mémoires 6, 7 chaque fois par un bus bidirectionnel (non référencé).

La carte 1 est représentée symboliquement introduite dans un lecteur 11. La carte possède 6 contacts K1, K2, K3, K4, K5 et K6 qui, dans cette position d'introduction, coopèrent avec 6 contacts homologues du lecteur et qui sont, en allant du bas vers le haut sur la figure, représentés d'une manière schématique sans respecter un ordre particulier: le contact d'entrée-sortie série I/O, le contact de masse GND, l'alimentation du microcircuit VCC (5 V), l'alimentation de programmation VPP, l'horloge CLK et la remise à zéro, RESET. Certains de ces 6 contacts sont reliés au microcircuit par l'intermédiaire de ports (non référencés). Au moyen d'une interface 12 et d'une liaison de communication, par exemple une ligne de transmission 13, le lecteur communique à distance avec un système hôte 14 qui comporte lui aussi une interface 15. La ligne de transmission 13 a été représentée symboliquement par deux fils, le fil 16 qui transmet de l'information du lecteur 11 vers le système hôte 14 et le fil 17 qui transmet l'information en sens inverse.

Le problème qui se pose est que lors d'une transaction, une donnée validant la transaction doit être écrite dans la mémoire EEPROM 7. Ceci devient particulièrement critique lorsque cette écriture n'est pas menée à son terme notamment à cause d'un arrachement de la carte ou d'une coupure d'alimentation. Pour valider cette transaction, c'est-à-dire ratifier la fin d'une opération d'écriture (ou de réécriture), l'invention propose d'utiliser la mémoire EEPROM en mémoire circulaire dont les emplacements sont repérés par les codes d'adresse A0, A1, ..., A4, A5, A6, l'inscription d'une donnée suivant celle située à l'emplalcement A6 se fera à l'emplacement A0... etc. ; une donnée est ratifiée si elle est contiguë à au moins deux emplacements "neutres". Pour une mémoire EEPROM conventionnelle, cela correspond à un effacement, le mot est alors "FF" en notation hexadécimale.

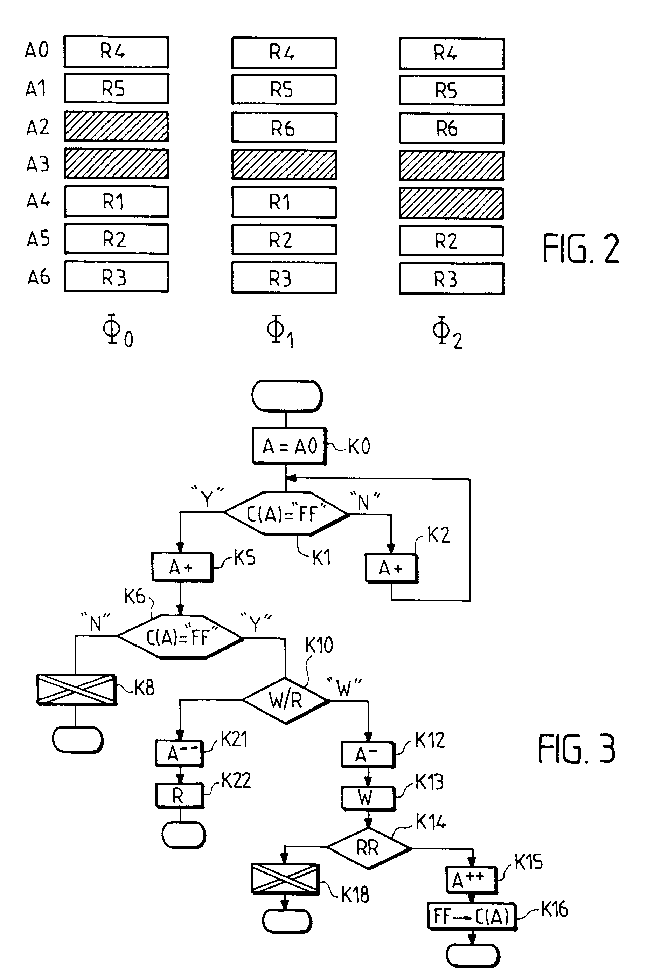

La figure 2 explicite le fonctionnement de l'invention.

Φ₀ représente l'état initial. L'information valide est R5 située à l'emplacement A1. Les deux éléments suivants, aux adresses A2 et A3, contiennent le code "FF" signifiant que ces deux cases ont déjà été effacées.

Φ₁ représente l'écriture de la donnée R6 à l'emplacement A2.

Φ₂ représente l'effacement de la donnée la plus ancienne R1. Cet effacement effectif constitue la validation de la donnée R6.

Ainsi, l'interruption de l'opération avant la fin normale de la phase 2 ne laissera qu'un seul enregistrement vierge dans la mémoire EEPROM 7 et donc, la donnée R6 sera considérée comme invalide.

Ce fonctionnement est gouverné par des lignes de programmes contenues dans la mémoire ROM 6.

Le programme montré à la figure 3 commence à la case K0 où un compteur d'adressage A (modulo 7) est initialisé par la valeur Ao qui correspond au premier emplacement de la mémoire circulaire. Puis, à la case K1 on teste si le contenu de cette case est vide ("FF") ou non. Si ce contenu n'est pas vide, on va à la case K2 où le compteur A est incrémenté d'une unité et on retourne à la case K1. Si le contenu de la mémoire circulaire est vide, on incrémente le compteur A d'une unité (case K5). On teste si l'emplacement suivant de la mémoire circulaire est vide ou non. S'il n'est pas vide, l'information n'est pas validée et un processus découlant de cette invalidation est déclenché (case K8). Ce processus ne faisant pas partie de l'invention n'a pas à être décrit. Si le test de la case K6 est positif on peut entreprendre une opération de lecture ou d'écriture en fonction d'un test indiqué à la case K10.

Une opération d'écriture commence par décrémenter d'une unité le compteur A (case K12) puis à écrire la donnée (case K13). Après avoir vérifié (par relecture) que la donnée est bonne (case K14) le compteur A est incrémenté de deux unités (case K15) puis l'emplacement pointé par ce compteur est effacé (case K16). Lorsque la donnée inscrite est fausse, le programme se débranche dans une routine de traitement d'erreur non décrit ici (case K18) et n'efface pas C(A).

Pour effectuer l'opération de lecture, le compteur A doit être décrémenté de deux unités (case K21) avant que la lecture s'effectue (case K22).

## Revendications

1. Dispositif comportant une mémoire (7) et des moyens de validation d'une donnée (R6) inscrite dans ladite mémoire, cette dernière étant organisée en mémoire circulaire, caractérisé en ce que lesdits moyens de validation assignent au moins deux emplacements "neutres" (A3, A4) résultant de leur effacement, contiguëment à l'emplacement de la mémoire (A2) où vient de s'inscrire la donnée à valider.

2. Dispositif selon la revendication 1, caractérisé en ce que ladite mémoire (7) est du type EEPROM.

## Patentansprüche

1. Anordnung mit einem Speicher (7) und Mitteln zur Validation von Daten (R6), die in dem Speicher eingeschrieben sind, wobei der Speicher als Umlaufspeicher ausgebildet ist, **dadurch gekennzeichnet,** daß die erwähnten Validationsmittel wenigstens zwei "neutrale" Plätze (A3, A4) bestimmen, die sich durch Löschung ihres Inhalts ergeben und an den Speicherplatz (A2) angrenzen, in den die zu validierenden Daten eingeschrieben werden sollen.

2. Vorrichtung nach Anspruch 1, dadurch gekennzeichnet, daß der erwähnte Speicher (7) ein EEPROM ist.

## Claims

1. Device comprising a memory (7) and means for validating data (R6) entered in the said memory, the latter being designed as a circular memory, characterised in that the said validating means assign at least two "neutral" locations (A3, A4) resulting from the erasure thereof contiguously with the location of the memory (A2) in which the data to be validated has been entered.

2. Device according to claim 1, characterised in that the said memory (7) is an EEPROM-type memory.
